(19) Europäisches Patentamt
European Patent Office
Office européen des brevets

(11) **EP 4 084 099 A1**

(12) **EUROPEAN PATENT APPLICATION**
published in accordance with Art. 153(4) EPC

(43) Date of publication:
**02.11.2022 Bulletin 2022/44**

(21) Application number: **20904307.4**

(22) Date of filing: **22.12.2020**

(51) International Patent Classification (IPC):
*H01L 35/14* $^{(2006.01)}$   *B22F 3/14* $^{(2006.01)}$
*B22F 9/04* $^{(2006.01)}$   *C01B 33/06* $^{(2006.01)}$
*C22C 1/05* $^{(2006.01)}$   *C22C 23/00* $^{(2006.01)}$
*H01L 35/22* $^{(2006.01)}$   *H01L 35/26* $^{(2006.01)}$

(52) Cooperative Patent Classification (CPC):
**C04B 35/58085; B22F 3/14; B22F 9/04;
C01B 33/06; C22C 1/05; C22C 23/00; H01L 35/14;
H01L 35/22; H01L 35/26;** C04B 2235/3813;
C04B 2235/3891; C04B 2235/40; C04B 2235/402;
C04B 2235/5436; C04B 2235/723;          (Cont.)

(86) International application number:
**PCT/JP2020/047992**

(87) International publication number:
**WO 2021/132255 (01.07.2021 Gazette 2021/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.12.2019   JP 2019233147
07.08.2020   JP 2020134901**

(71) Applicant: **Mitsubishi Materials Corporation
Tokyo 100-8117 (JP)**

(72) Inventor: **NAKADA, Yoshinobu
Saitama-shi, Saitama 330-8508 (JP)**

(74) Representative: **Hoffmann Eitle
Patent- und Rechtsanwälte PartmbB
Arabellastraße 30
81925 München (DE)**

(54) **THERMOELECTRIC CONVERSION MATERIAL, THERMOELECTRIC CONVERSION ELEMENT, AND THERMOELECTRIC CONVERSION MODULE**

(57)    A thermoelectric conversion material includes $Mg_2Si_XSn_{1-X}$ (where $0.3 \leq X \leq 1$) and a boride containing one or two or more metals selected from titanium, zirconium, and hafnium. Further, it is preferable that the boride is one or two or more selected from $TiB_2$, $ZrB_2$, and $HfB_2$.

FIG. 1

EP 4 084 099 A1

**(Cont. next page)**

(52) Cooperative Patent Classification (CPC): (Cont.)
   C04B 2235/80; C04B 2235/96; C04B 2235/9607

**Description**

TECHNICAL FIELD

The present invention relates to a thermoelectric conversion material including $Mg_2Si_XSn_{1-X}$ (where $0.3 \leq X \leq 1$) as a main component, a thermoelectric conversion element, and a thermoelectric conversion module.

Priority is claimed on Japanese Patent Application No. 2019-233147, filed December 24, 2019 and Japanese Patent Application No. 2020-134901, filed August 7, 2020, the contents of which are incorporated herein by reference.

BACKGROUND ART

A thermoelectric conversion element including a thermoelectric conversion material is an electronic element capable of mutually converting heat and electricity, as in Seebeck effect and Peltier effect. The Seebeck effect is an effect of converting heat energy into electric energy, and is a phenomenon in which an electromotive force is generated when a temperature difference is generated between both ends of a thermoelectric conversion material. Such an electromotive force depends on properties of the thermoelectric conversion material. In recent years, thermoelectric power generation utilizing the effect is actively developed.

The thermoelectric conversion element described above has a structure in which electrodes are each formed on one end side and the other end side of the thermoelectric conversion material.

As an index representing a property of the thermoelectric conversion element (thermoelectric conversion material), for example, a power factor (PF) represented by Equation (1) below or a dimensionless performance index (ZT) represented by Equation (2) below is used. In the thermoelectric conversion material, it is necessary to maintain a temperature difference between one end side and the other end side. Therefore, it is preferable that the thermoelectric conversion material has a low thermal conductivity.

$$PF = S^2\sigma \cdots (1)$$

Here, S: Seebeck coefficient (V/K), $\sigma$: Electric conductivity (S/m)

$$ZT = S^2\sigma T/\kappa \cdots (2)$$

Here, T = Absolute temperature (K), $\kappa$ = Thermal conductivity (W/(m $\times$ K))

As the thermoelectric conversion material described above, for example, as shown in Patent Document 1, a material obtained by adding various dopants to magnesium silicide is proposed.

Here, the thermoelectric conversion material made of the magnesium silicide tends to be easily oxidized, and there is a concern that the oxidation may cause deterioration of thermoelectric properties or the element may become brittle.

Therefore, for example, in Patent Document 2, a technique for preventing oxidation of a thermoelectric conversion material by covering the thermoelectric conversion material with glass is proposed.

[Citation List]

[Patent Documents]

[Patent Document 1]
Japanese Unexamined Patent Application, First Publication No. 2013-179322
[Patent Document 2]
Japanese Unexamined Patent Application, First Publication No. 2017-050325

SUMMARY OF INVENTION

Technical Problem

Meanwhile, as shown in Patent Document 2, in a case where a thermoelectric conversion material is covered with glass, the glass peels off due to a difference in a thermal expansion coefficient between the thermoelectric conversion material and the glass, and there is a concern that oxidation of the thermoelectric conversion material cannot be suppressed. In addition, it is necessary to cover an entire surface of the thermoelectric conversion material forming each thermoelectric conversion element with glass, thereby increasing manufacturing costs, which was a problem. Further, when the thermoelectric conversion material forming each thermoelectric conversion element is covered with glass, since the covering cannot be partially applied, a mottle may occur, or a thickness may become uneven due to flow of glass or the like. In such cases, the covering may be prone to be peeled.

In addition, since magnesium silicide is a brittle material, there is a concern of cracking during handling.

The present invention was made in view of circumstances described above, and an object of the present invention is to provide a thermoelectric conversion material that is excellent in a thermoelectric property, oxidation resistance, a strength, and fracture toughness, a thermoelectric conversion element using the thermoelectric conversion material, and a thermoelectric conversion module.

Solution to Problem

In order to achieve the aforementioned objects, a thermoelectric conversion material of the present invention includes $Mg_2Si_XSn_{1-X}$ (where $0.3 \leq X \leq 1$); and a boride containing one or two or more metals selected from titanium, zirconium, and hafnium.

According to the thermoelectric conversion material having the configuration, since the thermoelectric conversion material includes the boride containing one or two or more metals selected from titanium, zirconium, and hafnium, the boride is aggregated at a grain boundary of the $Mg_2Si_XSn_{1-X}$, which is a matrix, thereby improving an electrical conductivity and it is possible to improve a power factor (PF) which is one of indexes of the thermoelectric property.

In addition, since the boride contains one or two or more metals selected from titanium, zirconium, and hafnium, it is possible to suppress oxidation of magnesium and improve the oxidation resistance.

Further, since the boride described above is relatively hard and has high strength, it is possible to improve the strength of the thermoelectric conversion material and suppress occurrence of a crack during handling.

Here, in the thermoelectric conversion material of the present invention, the $Mg_2Si_XSn_{1-X}$ may be magnesium silicide with $X = 1$.

In this case, even in a case where the matrix is formed of magnesium silicide ($Mg_2Si$), the thermoelectric property, the oxidation resistance, the strength, and the fracture toughness are sufficiently excellent.

In addition, in the thermoelectric conversion material of the present invention, it is preferable that the boride is one or two or more selected from $TiB_2$, $ZrB_2$, and $HfB_2$.

In this case, since the boride is formed of one or two or more selected from $TiB_2$, $ZrB_2$, and $HfB_2$, it is possible to reliably improve the thermoelectric property, the oxidation resistance, and the strength.

In addition, in the thermoelectric conversion material of the present invention, it is preferable that a mass ratio of the $Mg_2Si_XSn_{1-X}$ to the thermoelectric conversion material is within a range of 84 mass% or more and 99.5 mass% or less.

In this case, since the mass ratio of the $Mg_2Si_XSn_{1-X}$ to the thermoelectric conversion material is within the range of 84 mass% or more and 99.5 mass% or less, sufficient thermoelectric property can be secured.

Further, in the thermoelectric conversion material of the present invention, it is preferable that a total amount of the boride is within a range of 0.5 mass% or more and 15 mass% or less.

In this case, since the total amount of the boride is within the range of 0.5 mass% or more and 15 mass% or less, it is possible to sufficiently improve the thermoelectric property, the oxidation resistance, and the strength.

Further, the thermoelectric conversion material of the present invention preferably further includes aluminum.

In this case, aluminum is added, whereby it is possible to further improve the thermoelectric property, the oxidation resistance, and mechanical strength.

Further, in the thermoelectric conversion material of the present invention, it is preferable that the amount of the aluminum to the thermoelectric conversion material is within a range of 0.01 mass% or more and 1 mass% or less.

In this case, since the amount of the aluminum with respect to the thermoelectric conversion material is within the above range, it is possible to reliably improve the thermoelectric property, oxidation resistance, and the mechanical strength.

A thermoelectric conversion element of the present invention includes the thermoelectric conversion material described above, and electrodes which are respectively joined to one surface and the other surface of the thermoelectric conversion material.

According to the thermoelectric conversion element having the configuration, since the thermoelectric conversion material having excellent thermoelectric property, oxidation resistance, and strength is provided, various properties are stabilized. Therefore, the thermoelectric conversion performance is stable and the reliability is excellent.

According to still another aspect of the present invention, a thermoelectric conversion module includes the thermoelectric conversion element described above; and terminals which are respectively joined to the electrodes of the thermoelectric conversion element.

According to the thermoelectric conversion module having the configuration, since the thermoelectric conversion element described above is provided, a thermoelectric conversion material has the excellent thermoelectric property, oxidation resistance, and strength, and various properties are stabilized. Therefore, the thermoelectric conversion performance is stable and the reliability is excellent.

Advantageous Effects of Invention

According to the present invention, it is possible to provide a thermoelectric conversion material having excellent thermoelectric property, oxidation resistance, and strength, a thermoelectric conversion element using the thermoelectric conversion material, and a thermoelectric conversion module.

BRIEF DESCRIPTION OF DRAWINGS

Fig. 1 is a sectional view showing a thermoelectric conversion material according to an embodiment of the present invention, a thermoelectric conversion element, and a thermoelectric conversion module.

Fig. 2 is a flowchart showing a method for manufacturing a thermoelectric conversion material according to the embodiment of the present invention.

Fig. 3 is a sectional view showing an example of a sintering apparatus used in the method for manufacturing a thermoelectric conversion material according to the embodiment of the present invention.

Fig. 4 is a flowchart showing a method for manufacturing a thermoelectric conversion material according to another embodiment of the present invention.

Fig. 5 is an appearance observation photograph showing a result of evaluating oxidation resistance in Test 2 of Example.

DESCRIPTION OF EMBODIMENTS

Hereinafter, a thermoelectric conversion material according to an embodiment of the present invention, a thermoelectric conversion element, and a thermoelectric conversion module will be described with reference to the accompanying drawings. Each embodiment to be described below is specifically described for better understanding of the gist of the invention, and does not limit the present invention unless otherwise specified. In addition, in the drawings used in the following description, for convenience, in order to make the features of the present invention easy to understand, a portion that is a main part may be enlarged in some cases, and a dimensional ratio or the like of each component is not always the same as an actual one.

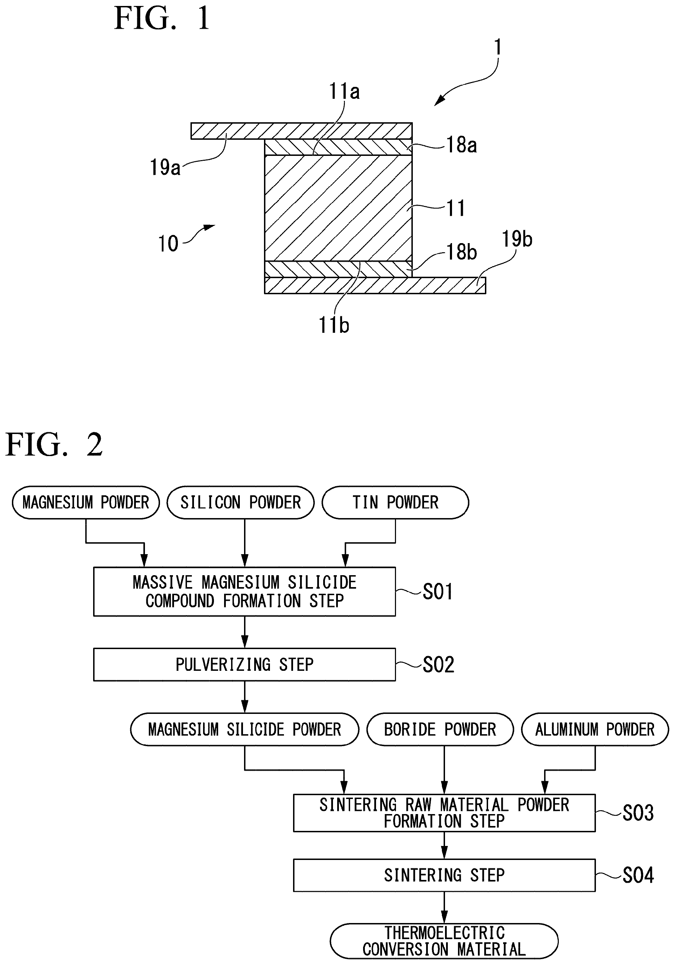

Fig. 1 shows a thermoelectric conversion material 11 according to an embodiment of the present invention, a thermoelectric conversion element 10 using the thermoelectric conversion material 11, and a thermoelectric conversion module 1.

The thermoelectric conversion element 10 includes the thermoelectric conversion material 11 according to the present embodiment, and electrodes 18a and 18b which are respectively formed on one surface 11a and the other surface 11b of the thermoelectric conversion material 11.

In addition, the thermoelectric conversion module 1 includes terminals 19a and 19b which are respectively joined to the electrodes 18a and 18b of the thermoelectric conversion element 10 described above.

For the electrodes 18a and 18b, nickel, silver, cobalt, tungsten, molybdenum, or the like is used. The electrodes 18a and 18b can be formed by electric sintering, plating, electrodeposition, or the like.

The terminals 19a and 19b are formed of a metal material excellent in conductivity, for example, a plate material such as copper or aluminum. In the present embodiment, a rolled aluminum plate is used. In addition, the thermoelectric conversion element 10 (the electrodes 18a and 18b) and the terminals 19a and 19b can be joined together, by Ag brazing, Ag plating, or the like.

Moreover, the thermoelectric conversion material 11 of the present embodiment is formed of a sintered body containing $Mg_2Si_XSn_{1-X}$ (where $0.3 \leq X \leq 1$) as a main component.

Here, the thermoelectric conversion material 11 may be formed of non-doped $Mg_2Si_XSn_{1-X}$ having no dopant, and may be formed of $Mg_2Si_XSn_{1-X}$ containing, as a dopant, one or two or more selected from Li, Na, K, B, Ga, In, N, P, As, Sb, Bi, Ag, Cu, and Y.

In the present embodiment, the thermoelectric conversion material 11 includes, as a main component, $Mg_2Si_XSn_{1-X}$ with a mass ratio of 84 mass% or more and 99.5 mass% or less, and the $Mg_2Si_XSn_{1-X}$ is formed by adding, as a dopant, antimony (Sb).

For example, the thermoelectric conversion material 11 of the present embodiment has a composition in which the antimony is added in a range of 0.1 atom% or more and 2.0 atom% or less to $Mg_2Si_XSn_{1-X}$. In the thermoelectric conversion material 11 of the present embodiment, an n-type thermoelectric conversion material having a high carrier density is obtained by adding the antimony which is a pentavalent donor.

Here, as the donor for obtaining the n-type thermoelectric conversion element from the thermoelectric conversion material 11, bismuth, phosphorus, arsenic, and the like can be used in addition to the antimony.

Furthermore, the thermoelectric conversion material 11 may be formed to be a p-type thermoelectric conversion element. In this case, the p-type thermoelectric conversion element can be obtained by adding a dopant such as lithium or silver as an acceptor.

Moreover, the thermoelectric conversion material 11 of the present embodiment contains a boride containing one or two more metals selected from titanium, zirconium, and hafnium which are the group 4 elements. Examples of the boride include $TiB_2$, $ZrB_2$, and $HfB_2$. It is preferable that these borides are aggregated at a grain boundary of the $Mg_2Si_XSn_{1-X}$, which is a matrix.

Here, in the present embodiment, it is preferable that a total amount of the boride is within a range of 0.5 mass% or more and 15 mass% or less.

In addition, a lower limit of the total amount of the boride is more preferably 1 mass% or more, and further preferably 1.5 mass% or more. On the other hand, an upper limit of the total amount of the boride is more preferably 12 mass% or less, and further preferably 10 mass% or less.

The thermoelectric conversion material 11 of the present embodiment may contain aluminum.

In a case where the aluminum is added, the thermoelectric property, the oxidation resistance, and mechanical strength is further improved.

Here, the amount of aluminum added is preferably in a range of 0.01 mass% or more and 1 mass% or less.

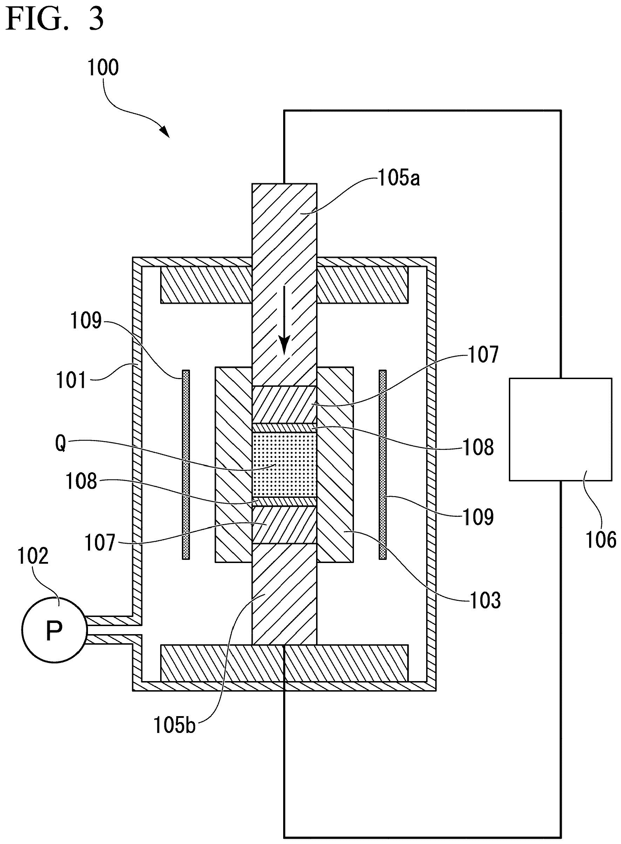

Next, a method for manufacturing the thermoelectric conversion material 11 according to the present embodiment will be described with reference to Figs. 2 and 3.

(Massive Magnesium Silicide Compound Formation Step S01)

First, a massive magnesium silicide compound, which is a raw material of the $Mg_2Si_XSn_{1-X}$ which is a matrix of the sintered body as the thermoelectric conversion material 11 is formed.

In the massive magnesium silicide compound formation step S01, a silicon powder and a magnesium powder, and a tin powder and a dopant which will be added as needed are respectively weighed and mixed. For example, in a case of forming an n-type thermoelectric conversion material, a pentavalent material such as antimony or bismuth is mixed as a dopant. Also, in a case of forming a p-type thermoelectric conversion material, a material such as lithium or silver is mixed as a dopant. In addition, non-doped $Mg_2Si_XSn_{1-X}$ may be used without adding the dopant.

In the present embodiment, antimony is used as a dopant in order to obtain an n-type thermoelectric conversion material, and the amount of antimony added is within a range of 0.1 atom% or more and 2.0 atom% or less.

Then, the mixed powder is introduced into, for example, an alumina crucible. In a case where the sintering raw material powder is $Mg_2Si_XSn_{1-X}$ (X = 1), heating is performed to be in a range of 800°C or higher and 1150°C or lower, and in a case where the sintering raw material powder is $Mg_2Si_XSn_{1-X}$ ($0.3 \leq X < 1$), heating is performed to be in a range of 700°C or higher and 900°C or lower, and cooling and solidification are performed. As a result, a massive magnesium silicide compound is obtained.

Since a small amount of magnesium sublimates during heating, it is preferable to add a large amount of magnesium, for example, approximately 3 atom% to 5 atom% of magnesium, to a stoichiometric composition, when measuring the raw materials.

(Pulverizing Step S02)

Next, the obtained massive magnesium silicide compound is pulverized by a pulverizer to form a magnesium silicide compound powder ($Mg_2Si_XSn_{1-X}$ powder).

In a pulverizing step S02, an average particle size of the magnesium silicide compound powder is preferably within a range of 1 μm or larger and 100 μm or smaller.

With respect to the magnesium silicide compound powder to which a dopant is added, the dopant is uniformly present in the magnesium silicide compound powder.

In a case where a commercially available magnesium silicide compound powder or a magnesium silicide compound powder to which a dopant is added is used, the massive magnesium silicide compound formation step S01 and the pulverizing step S02 can be omitted.

(Sintering raw material powder formation step S03)

Next, the obtained magnesium silicide compound powder is mixed with a boride powder containing one or two or more metals selected from titanium, zirconium, and hafnium to obtain a sintering raw material powder. An aluminum powder may be added as needed.

The amount of the magnesium silicide compound powder in the sintering raw material powder is preferably within a range of 84 mass% or more and 99.5 mass% or less.

Here, the amount of the boride powder in the sintering raw material powder is preferably within a range of 0.5 mass% or more and 15 mass% or less. In addition, as the boride powder, it is preferable to use a powder having a purity of 99 mass% or higher. Furthermore, an average particle size of the boride powder is preferably within a range of 1 $\mu$m or larger and 100 $\mu$m or smaller.

In addition, in a case of adding an aluminum powder, the amount of the aluminum powder in the sintering raw material powder is preferably within a range of 0.01 mass% or more and 1 mass% or less. As the aluminum powder, it is preferable to use a powder having a purity of 99.99 mass% or higher. Furthermore, an average particle size of the aluminum powder is preferably within a range of 1 $\mu$m or larger and 100 $\mu$m or smaller.

(Sintering Step S04)

Next, the sintering raw material powder obtained as described above is heated while applying pressure to obtain a sintered body. Here, in the present embodiment, in the sintering step S04, a sintering apparatus (an electric sintering apparatus 100) shown in Fig. 3 is used.

The sintering apparatus (electric sintering apparatus 100) shown in Fig. 3 includes, for example, a pressure-resistant housing 101, a vacuum pump 102 for reducing the pressure inside the pressure-resistant housing 101, and a hollow tubular carbon mold 103 disposed on an inside of the pressure-resistant housing 101, a pair of electrode portions 105a and 105b for applying a current while pressing a sintering raw material powder Q with which the carbon mold 103 is filled, and a power supply device 106 for applying a voltage between the pair of electrode portions 105a and 105b. In addition, a carbon plate 107 and a carbon sheet 108 are respectively provided between the electrode portions 105a and 105b and the sintering raw material powder Q. In addition to these, a thermometer, a displacement gauge, and the like (which are not shown) are provided. In addition, in the present embodiment, a heater 109 is provided on an outer peripheral side of the carbon mold 103. The heater 109 is disposed on four sides so as to cover the entire surface of the carbon mold 103 on outer peripheral side. As the heater 109, a carbon heater, a nichrome wire heater, a molybdenum heater, a Kanthal wire heater, a high frequency heater, or the like can be used.

In a sintering step S04, first, the carbon mold 103 of the electric sintering apparatus 100 shown in Fig. 3 is filled with the sintering raw material powder Q. For example, the inside of the carbon mold 103 is covered with a graphite sheet or a carbon sheet. Then, a direct current is applied between the pair of electrode portions 105a and 105b by using the power supply device 106, and a direct current is applied to the sintering raw material powder Q. Accordingly, a temperature increases by self-heating. In addition, between the pair of electrode portions 105a and 105b, the electrode portion 105a on a movable side is caused to move toward the sintering raw material powder Q, and the sintering raw material powder Q is pressed at a predetermined pressure between the electrode portion 105a and the electrode portion 105b on a fixed side. In addition, the heater 109 is heated.

Accordingly, the sintering raw material powder Q is sintered by the heat from the self-heating of the sintering raw material powder Q and the heater 109 and the pressurizing.

In the present embodiment, sintering conditions in the sintering step S04 are set such that a sintering temperature is within a range of 800°C or higher and 1020°C or lower in a case where the sintering raw material powder Q is $Mg_2Si_XSn_{1-X}$ (X = 1), the sintering temperature is within a range of 600°C or higher and 800°C or lower in a case where the sintering raw material powder Q is $Mg_2Si_XSn_{1-X}$ (0.3 ≤ X <1), and holding time at each sintering temperature is 10 minutes or shorter.

In addition, pressing load is in a range of 20 MPa or more and 50 MPa or less.

In addition, an atmosphere in the pressure-resistant housing 101 may be an inert atmosphere such as an argon atmosphere or a vacuum atmosphere. When the vacuum atmosphere is set, the pressure may be set to 5 Pa or less.

Here, in a case where the sintering temperature of the sintering raw material powder Q ($Mg_2Si_XSn_{1-X}$ (X = 1)) is lower than 800°C or in a case where the sintering temperature of the sintering raw material powder Q ($Mg_2Si_XSn_{1-X}$ (0.3 ≤ X <1)) is lower than 600°C, an oxide film formed on a surface of each powder of the sintering raw material powder Q cannot be sufficiently removed, a surface oxide film of the raw material powder itself remains at grain boundaries, and bonding between the raw material powders is insufficient, resulting in a low density of the sintered body. For these reasons, there is a concern that an electrical resistance of the obtained thermoelectric conversion material may increase. In addition, since bonding between the raw material powders is insufficient, there is a concern that the strength of the element is low.

On the other hand, in a case where the sintering temperature of the sintering raw material powder Q ($Mg_2Si_XSn_{1-X}$ (X = 1)) is higher than 1020°C or in a case where the sintering temperature of the sintering raw material powder Q ($Mg_2Si_XSn_{1-X}$ ($0.3 \leq X < 1$)) is higher than 800°C, a decomposition of $Mg_2Si_XSn_{1-X}$ ($0.3 \leq X \leq 1$) proceeds in short time, and there are concerns that the composition shifts, the electrical resistance increases, and the Seebeck coefficient decreases.

Therefore, in the present embodiment, the sintering temperature in the sintering step S04 is set to be within a range of 800°C or higher and 1020°C or lower in the case of the sintering raw material powder Q ($Mg_2Si_XSn_{1-X}$ (X = 1)), and set to be within in a range of 600°C or higher and 800°C or lower in a case of the sintering raw material powder Q ($Mg_2Si_XSn_{1-X}$ ($0.3 \leq X < 1$)).

A lower limit of the sintering temperature of the sintering raw material powder Q ($Mg_2Si_XSn_{1-X}$ (X = 1)) in the sintering step S04 is preferably 800°C or higher, and further preferably 900°C or higher. On the other hand, an upper limit of the sintering temperature of the sintering raw material powder Q ($Mg_2Si_XSn_{1-X}$ (X = 1)) in the sintering step S04 is preferably 1020°C or lower, and further preferably 1000°C or lower.

In addition, a lower limit of the sintering temperature of the sintering raw material powder Q ($Mg_2Si_XSn_{1-X}$ ($0.3 \leq X < 1$)) in the sintering step S04 is preferably 650°C or higher. On the other hand, an upper limit of the sintering temperature of the sintering raw material powder Q ($Mg_2Si_XSn_{1-X}$ ($0.3 \leq X < 1$)) in the sintering step S04 is preferably 770°C or lower, and further preferably 740°C or lower.

Also, in a case where the holding time at the sintering temperature exceeds 10 minutes, a decomposition of $Mg_2Si_XSn_{1-X}$ proceeds, and there are concerns that the composition shifts, the electrical resistance increases, and the Seebeck coefficient decreases. Furthermore, there are concerns that the particles may become coarse and the thermal conductivity may increase.

Therefore, in the present embodiment, the holding time at the sintering temperature in the sintering step S04 is set to 10 minutes or shorter.

An upper limit of the holding time at the sintering temperature in the sintering step S04 is preferably 5 minutes or shorter, and further preferably 3 minutes or shorter.

Furthermore, in a case where the pressing load in the sintering step S04 is less than 20 MPa, there are concerns that the density does not increase and the electrical resistance of the thermoelectric conversion material may increase. In addition, there is a concern that the strength of the element does not increase.

On the other hand, in a case where the pressing load in the sintering step S04 exceeds 50 MPa, there are concerns that a force applied to the carbon jig is large and the jig may be broken.

Therefore, in the present embodiment, the pressing load in the sintering step S04 is set within a range of 20 MPa or more and 50 MPa or less.

A lower limit of the pressing load in the sintering step S04 is preferably 23 MPa or more, and further preferably 25 MPa or more. On the other hand, an upper limit of the pressing load in the sintering step S04 is preferably 50 MPa or less, and further preferably 45 MPa or less.

According to the above steps, the thermoelectric conversion material 11 according to the present embodiment is manufactured.

According to the thermoelectric conversion material 11 having the configuration according to the present embodiment, since the thermoelectric conversion material includes the boride containing one or two or more metals selected from titanium, zirconium, and hafnium, the boride is aggregated at a grain boundary of the $Mg_2Si_XSn_{1-X}$, which is a matrix, thereby improving an electrical conductivity and it is possible to improve a power factor (PF) which is one of indexes of the thermoelectric property.

In addition, since the boride contains one or two or more metals selected from titanium, zirconium, and hafnium, it is possible to suppress oxidation of magnesium and improve the oxidation resistance.

Further, since the boride described above is relatively hard and has high strength, it is possible to improve the strength of the sintered body including $Mg_2Si_XSn_{1-X}$ as the main component, and suppress occurrence of a crack during handling.

In addition, in the present embodiment, in a case where the total amount of the boride is within the range of 0.5 mass% or more and 15 mass% or less, it is possible to sufficiently improve the thermoelectric property, the oxidation resistance, and the strength.

Furthermore, in the present embodiment, in a case where the boride is one or two or more selected from $TiB_2$, $ZrB_2$, and $HfB_2$, it is possible to reliably improve the thermoelectric property, the oxidation resistance, and the strength.

In addition, in the present embodiment, in a case where the mass ratio of the $Mg_2Si_XSn_{1-X}$ to the thermoelectric conversion material 11 is within the range of 84 mass% or more and 99.5 mass% or less, sufficient thermoelectric property can be secured.

Furthermore, in the present embodiment, in a case where the thermoelectric conversion material 11 contains aluminum, it is possible to further improve the thermoelectric property, the oxidation resistance, and the mechanical strength.

Further, since the thermoelectric conversion element 10 and the thermoelectric conversion module 1 according to the present embodiment include the thermoelectric conversion material 11 described above having excellent thermoelectric property, the oxidation resistance, and the strength, various properties are stabilized. Therefore, the thermoelectric conversion performance is stable, and the reliability is excellent.

As described above, the embodiments of the present invention are described. However, the present invention is not limited thereto, and can be appropriately modified without departing from the technical idea of the present invention.

For example, in the present embodiment, it was described that the thermoelectric conversion module having a structure as shown in Fig. 1 are configured. However, the present invention is not limited thereto, and there is no particular limitation on a structure and disposition of the electrodes or terminals, as long as the thermoelectric conversion material of the present embodiment is used.

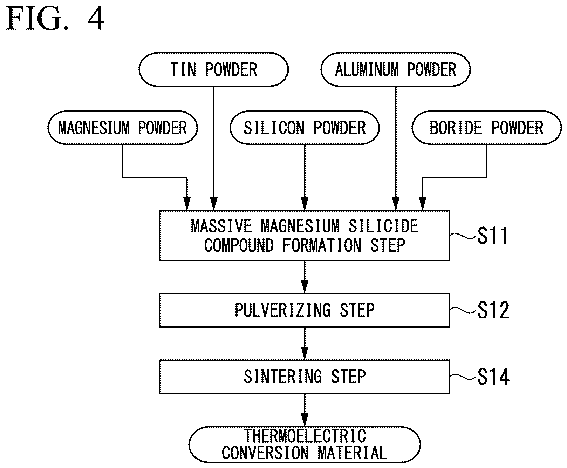

In addition, in the present embodiment, as shown in Fig. 2, it has been described that the sintering raw material powder is formed by adding the boride powder to the magnesium silicide compound powder ($Mg_2Si_xSn_{1-X}$ powder), but the present invention is not limited thereto. As shown in Fig. 4, the sintering raw material powder may be formed in a manner that a magnesium powder, a silicon powder (as needed, a tin powder), and a boride powder are mixed, the mixed powder is introduced into, for example, an alumina crucible, and heated to be within a range of 800°C or higher and 1150°C or lower, or within a range of 700°C or higher and 900°C or lower (in a case of adding the tin powder), and cooled and solidified, and the obtained massive magnesium silicide compound ($Mg_2Si_xSn_{1-X}$) is pulverized.

Further, in the present embodiment, it was described that the sintering is performed using the sintering apparatus (electric sintering apparatus 100) shown in Fig. 3, but the present invention is not limited thereto, and a method in which the sintering raw material is sintered by pressing while indirectly heating, for example, hot pressing, hot isotactic pressing (HIP), or the like may be used.

Further, in the present embodiment, it was described that a powder of the magnesium silicide compound powder ($Mg_2Si_xSn_{1-X}$ powder) to which antimony (Sb) is added as a dopant is used as the sintering raw material, but the present invention is not limited thereto. For example, one or two or more selected from Li, Na, K, B, Ga, In, N, P, As, Sb, Bi, Ag, Cu, and Y may be contained as the dopant, or these elements may be contained in addition to Sb.

In addition, a sintered body of the non-doped magnesium silicide compound ($Mg_2Si_xSn_{1-X}$) having no dopant may be used.

[Examples]

Hereinafter, results of experiments performed to confirm the effects of the present invention will be described.

(Test 1)

In this test 1, the thermoelectric properties of the thermoelectric conversion material containing magnesium silicide ($Mg_2Si$) as a main component were evaluated in Present Examples 1 to 5 and Comparative Example 1.

Mg with a purity of 99.9 mass% (particle size of 180 $\mu$m, manufactured by Kojundo Chemical Laboratory Co., Ltd.), Si with a purity of 99.99 mass% (particle size of 300 $\mu$m, manufactured by Kojundo Chemical Laboratory Co., Ltd.), and Sb with a purity of 99.9 mass% (particle size of 300 $\mu$m, manufactured by Kojundo Chemical Laboratory Co., Ltd.) were prepared, weighed, mixed well in a mortar, placed in an alumina crucible and heated at 850°C for 2 hours in Ar-3vol% $H_2$. In consideration of deviation from Mg:Si = 2:1 of a stoichiometric composition due to sublimation of Mg, Mg was mixed by 5 atom% more. Accordingly, a massive magnesium silicide ($Mg_2Si$) having a composition of Present Examples 1 to 5 and Comparative Example 1 shown in Table 1 was obtained.

Next, this massive magnesium silicide ($Mg_2Si$) was coarsely pulverized in a jaw crusher, further finely pulverized in a mortar, and this was classified to obtain a magnesium silicide powder ($Mg_2Si$ powder) having an average particle size of 30 $\mu$m.

In addition, a boride powder shown in Table 1 (purity 99.9 mass%, average particle size 3 $\mu$m) is prepared. The boride powder was weighed so as to have the amount shown in Table 1, and a magnesium silicide powder and the boride powder were mixed to obtain a sintering raw material powder.

A carbon mold whose inside was covered with a carbon sheet was filled with the obtained sintering raw material powder. Thus, electric sintering was performed by the sintering apparatus (electric sintering apparatus 100) shown in Fig. 3 in conditions shown in Table 1.

Moreover, the obtained sintered body was cut to have a predetermined size using a diamond band saw, and a surface of the cut sintered body was polished with sandpaper of various counts. As a result, a thermoelectric conversion material having the composition shown in Table 1 was obtained.

A thermal conductivity $\kappa$, a power factor PF, and a dimensionless performance index ZT at various temperatures were evaluated for the thermoelectric conversion materials obtained as described above. Table 1 shows evaluation results.

A specific resistance value R and the Seebeck coefficient S were measured by ZEM-3 (manufactured by Advance Riko, Inc.). Measurement of the specific resistance value R and the Seebeck coefficient S were performed at 100°C, 200°C, 300°C, 400°C, and 500°C.

The power factor (PF) was determined from Equation (1) below.

$$PF = S^2/R \cdots (1)$$

S: Seebeck coefficient (V/K), R: Specific resistance value ($\Omega \cdot$m)

The thermal conductivity $\kappa$ was determined from "thermal diffusivity $\times$ density $\times$ specific heat capacity". The thermal diffusivity was measured using a thermal constant measuring device (Model TC-7000 manufactured by Vacuum Riko, Inc). The density was measured using an Archimedes method. The specific heat was measured using a differential scanning calorimeter (Model DSC-7 manufactured by Perkin Elmer). The measurement was performed at 25°C, 100°C, 200°C, 300°C, 400°C, and 500°C.

The dimensionless performance index (ZT) was determined from Equation (2) below.

$$ZT = S^2\sigma T/\kappa \cdots (2)$$

Here, T = Absolute temperature (K), $\kappa$ = Thermal conductivity (W/(m $\times$ K))

[Table 1]

| | Magnesium silicide | Boride | | Thermoelectric property evaluation | | | | | | |
|---|---|---|---|---|---|---|---|---|---|---|
| | | Kind | Amount (mass%) | Evaluation item | 25°C | 100°C | 200°C | 300°C | 400°C | 500°C |
| Present Example 1 | Sb doped (0.2 atom%) | TiB$_2$ | 3.0 | Thermal conductivity | 9.83 | 7.87 | 6.32 | 4.88 | 4.17 | 3.72 |
| | | | | PF | | 1.93E-03 | 2.46E-03 | 2.65E-03 | 2.57E-03 | 2.35E-03 |
| | | | | ZT | | 0.09 | 0.18 | 0.31 | 0.42 | 0.49 |
| Present Example 2 | Sb doped (0.2 atom%) | ZrB$_2$ | 3.0 | Thermal conductivity | 12.70 | 10.8 | 8.76 | 4.79 | 4.14 | 3.69 |
| | | | | PF | | 1.62E-03 | 2.37E-03 | 2.58E-03 | 2.52E-03 | 2.31 E-03 |
| | | | | ZT | | 0.06 | 0.13 | 0.31 | 0.41 | 0.48 |
| Present Example 3 | Sb doped (0.2 atom%) | TiB$_2$ | 9.8 | Thermal conductivity | 10.50 | 8.92 | 7.41 | 5.50 | 4.76 | 4.28 |
| | | | | PF | | 2.03E-03 | 2.53E-03 | 2.66E-03 | 2.66E-03 | 2.41 E-03 |
| | | | | ZT | | 0.08 | 0.16 | 0.28 | 0.38 | 0.44 |
| Present Example 4 | Sb doped (0.2 atom%) | ZrB$_2$ | 10.0 | Thermal conductivity | 10.70 | 8.71 | 6.82 | 5.37 | 4.65 | 4.12 |
| | | | | PF | | 1.72E-03 | 2.36E-03 | 2.57E-03 | 2.55E-03 | 2.33E-03 |
| | | | | ZT | | 0.07 | 0.16 | 0.27 | 0.37 | 0.44 |
| Present Example 5 | Sb doped (0.2 atom%) | TiB$_2$ | 1.1 | Thermal conductivity | 9.14 | 7.45 | 5.91 | 4.58 | 3.94 | 3.56 |
| | | | | PF | | 1.82E-03 | 2.42E-03 | 2.62E-03 | 2.51 E-03 | 2.35E-03 |
| | | | | ZT | | 0.09 | 0.19 | 0.33 | 0.43 | 0.51 |
| Comparative Example 1 | Sb doped (0.2 atom%) | - | - | Thermal conductivity | 9.07 | 7.27 | 5.69 | 4.84 | - | - |
| | | | | PF | | 1.58E-03 | - | 2.50E-03 | - | 2.28E-03 |
| | | | | ZT | | 0.08 | - | 0.30 | - | - |

Thermal conductivity (W/m·K)
PF (W/m·K$^2$)

In Present Examples 1 to 5 in which the boride was added, it was confirmed that the power factor PF was high at various temperatures and the thermoelectric properties (power generation performance and thermoelectric conversion efficiency) were excellent, comparing to Comparative Example 1 in which boride was not added.

(Test 2)

In this test 2, the oxidation resistance was evaluated. The thermoelectric conversion materials having the compositions shown in Present Examples 11 and 12 and Comparative Examples 11 and 12 in Table 2 were obtained by the same manufacturing method as in the test 1.

The thermoelectric conversion material obtained as described above was subjected to an oxidative heat treatment in which the thermoelectric conversion material was heated to 750°C in a steam atmosphere of 200 Pa, and then cooled without holding time.

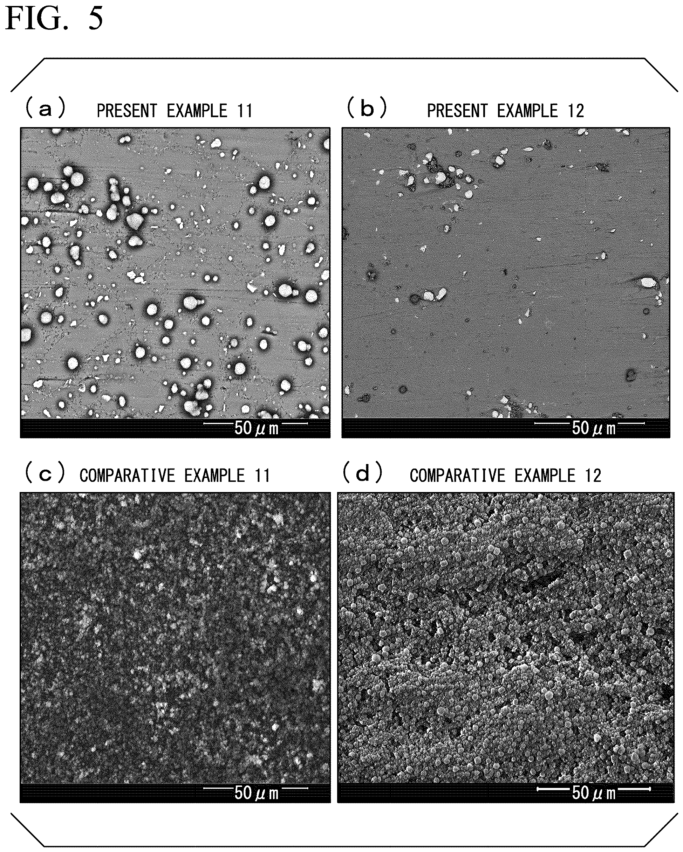

Moreover, samples taken from the thermoelectric conversion material before and after the heat treatment were analyzed by energy dispersive X-ray analysis (EDX), and the composition on a surface thereof was confirmed. Table 2 shows measurement results. In addition, Fig. 5 shows a surface observation photograph after the heat treatment.

[Table 2]

| | Magnesium silicide | Boride | | EDX analysis result of surface (atom%) | | | | | |
|---|---|---|---|---|---|---|---|---|---|
| | | Kind | Amount (mass%) | Before heat treatment | | | After heat treatment | | |
| | | | | O | Mg | Si | O | Mg | Si |
| Present Example 11 | Sb doped (0.2 atom%) | TiB$_2$ | 3.0 | 0.02 | 66.87 | 32.76 | 6.59 | 63.40 | 29.59 |
| Present Example 12 | Sb doped (0.2 atom%) | TiB$_2$ | 9.8 | 0.14 | 66.86 | 32.71 | 4.78 | 64.77 | 31.17 |
| Comparative Example 11 | Sb doped (0.2 atom%) | - | - | 0.26 | 66.73 | 32.76 | 37.15 | 59.46 | 3.02 |
| Comparative Example 12 | Sb doped (0.5 atom%) | | - | 0.13 | 67.04 | 32.05 | 38.30 | 60.82 | 0.72 |

In Comparative Examples 11 and 12 in which boride was not added, the amount of an oxygen (O) was high and the amount of a silicon (Si) was low after the heat treatment. As shown in (c) and (d) in Fig. 5, it is presumed that a magnesium oxide was densely formed on the surface, and the detected amount of silicon of the magnesium silicide reduces.

On the other hand, in Present Examples 11 and 12 in which the boride was added, the amount of oxygen (O) was slightly higher after the heat treatment, but there was no significant change in the amount of magnesium (Mg) and silicon (Si). As shown in (a) and (b) in Fig. 5, it is presumed that the formation of the magnesium oxide was suppressed, silicon of magnesium silicide was sufficiently detected.

The white portions in (a) and (b) in Fig. 5 are magnesium oxides, and EDX values in Table 2 are the results of measurements other than the spherical white portions (ground portions). On the other hand, in (c) and (d) of the comparative examples, since the entire surface of the sample was covered with the magnesium oxide, the results are obtained by performing analysis on the magnesium oxide.

The following reactions are considered as one of mechanisms by which the oxidation of magnesium silicide to which boride is added is suppressed. First, a part of the boride in contact with magnesium silicide reacts with magnesium silicide and decomposes into titanium, zirconium, hafnium, or boron, and these elements diffuse into magnesium silicide particles to form magnesium, a compound of these elements, and the like. It is considered that the compound suppresses the diffusion of magnesium to the surface of the thermoelectric conversion material and prevents the oxidation of magnesium silicide. Alternatively, it is considered that the compound suppresses the diffusion of oxygen into the thermoelectric conversion material and suppresses the oxidation of magnesium silicide.

(Test 3)

In this test 3, the strength was evaluated. The thermoelectric conversion materials having the compositions shown in Present Examples 21 and 26 and Comparative Example 21 in Table 3 were obtained by the same manufacturing method as in the test 1.

The thermoelectric conversion material obtained as described above was subjected to a three-point bending test at the temperatures shown in Table 3 in a range of room temperature (25°C) to 550°C, and a bending strength was measured. In addition, a ratio between the bending strength at 500°C and the bending strength at room temperature (25°C) was calculated. Table 3 shows measurement results.

For a three-point bending tester, Shimadzu Autograph (AG-25TD) was used. A test jig was a three-point bending jig made of SiC, and a distance between fulcrums was 12 mm.

A test atmosphere was an atmosphere at room temperature and an Ar atmosphere at 300°C to 550°C. A displacement rate of crosshead was 0.5 mm/min, a temperature increasing rate was 20°C/min, and the temperature was held for 15 minutes after reaching the test temperature, and then the three-point bending test was performed. For the bending strength, the bending strength (MPa) was determined from the maximum load at the time of breaking by using the following equation.

$$\text{Bending strength (MPa)} = 3/2 \times F_{max} \times L/(t^2 \times W)$$

$F_{max}$: Maximum load (N), L: Distance between fulcrums (mm)
t: Test piece thickness (mm), W: Test piece width (mm)

[Table 3]

| | Magnesium silicide | Boride | | Three-point bending test | | | | | Bending Strength at 500°C/ Bending Strength at 25°C |
| | | Kind | Amount (mass%) | Bending strength (MPa) | | | | | |
| | | | | 25°C | 300°C | 400°C | 500°C | 550°C | |
| Present Example 21 | Sb doped (0.2 atom%) | TiB$_2$ | 1.1 | 94.0 | - | - | 146.5 | - | 1.56 |
| Present Example 22 | Sb doped (0.2 atom%) | TiB$_2$ | 3.0 | 94.6 | 92.8 | 172.2 | 194.8 | 235.8 | 2.06 |
| Present Example 23 | Sb doped (0.2 atom%) | TiB$_2$ | 5.0 | 92.6 | 107.6 | - | 151.3 | - | 1.63 |
| Present Example 24 | Sb doped (0.5 atom%) | TiB$_2$ | 10.0 | 98.2 | - | - | 157.2 | - | 1.60 |
| Present Example 25 | Sb doped (0.2 atom%) | TiB$_2$ | 2.0 | 96.3 | - | - | 155.7 | - | 1.62 |
| Present Example 26 | Sb doped (0.2 atom%) | TiB$_2$ | 4.0 | 88.6 | - | - | 191.5 | - | 2.16 |
| Comparative Example 21 | Sb doped (0.2 atom%) | - | - | 96.1 | 96.9 | - | 133.7 | - | 1.39 |

In Present Examples 21 to 26 in which the boride was added, an increase range of the bending strength at a high temperature (500°C) with respect to the bending strength at room temperature (25°C) (bending strength at 500°C/Bending strength at 25°C) was sufficiently higher than that of Comparative Example 21. In addition, the bending strength at the high temperature (500°C) was also higher than that of Comparative Example 21. The reason for this is considered as follows.

In general, the bending strength of a boride is 400 MPa at room temperature in Ar, and the strength is almost constant up to 1400°C when the temperature is increased. The sample here is in a state where the boride is aggregated at a grain boundary to form a thin layer and is sintered. On the other hand, it is considered that the strength of a bulk body depends on the particle strength and the grain boundary strength configuring the bulk body. In this case, it seems that since the bending strength of the three-point bending is almost the same, at room temperature, regardless of the addition of the boride, the strength is mainly determined by the particle strength of magnesium silicide.

In a case where the bending test was performed at a temperature of 500°C, the strength increased from room temperature, but the increase range was small in a case of no addition, and the addition amount had a peak in the vicinity of 3 mass% to 4 mass%, and the strength thereof was equal to more than doubled. This indicates that the strength of the bulk body is increases to be equal to or higher than the strength of magnesium silicide. It is considered that the reason for this is that the bonding force between the boride particles and the magnesium silicide particles in contact with each other at the grain boundary was improved, which leads to an increase in the bending strength at a high temperature.

The reason why the peak is in the vicinity of 3 mass% to 4 mass% is considered to be as follows. Regarding the sintering of the boride, the boride is sintered by adding a sintering aid or the like, undergoing several steps (including a pressurizing step such as hot pressing), and finally sintered at a high temperature of about 2000°C. In this case, it is considered that in a case where the addition amount is increased to about 10 mass%, the thickness of the grain boundary formed by the boride becomes large, and the cases where the borides come into contact with each other increase. However, it is considered that since in sintering of the magnesium silicide, the temperature is at most 1020°C and a sintering aid is not added, the strength of the borides formed at the grain boundary becomes lower than the true strength of the boride. Therefore, in a case where the amount of boride added is too large, the strength becomes lower, comparing to 4 mass%. In addition, in a case of less than 3 mass%, the magnesium silicide particles are not sufficiently covered with the boride, and the strength is lower comparing to 3 mass%. From a different point of view, it is considered that the maximum strength was obtained in the vicinity of 3 mass% to 4 mass% where magnesium silicide was covered with the boride in just proportion.

(Test 4)

In this test 4, fracture toughness was evaluated. The thermoelectric conversion materials having the compositions shown in Present Examples 31 and 32 and Comparative Example 31 in Table 4 were obtained by the same manufacturing method as in the test 1.

The fracture toughness Kc of the obtained thermoelectric conversion material was measured by an IF method specified in JIS R1607. In this test, measurement was performed by performing a micro Vickers test by using an HSV-30 manufactured by Shimadzu Corporation, under the conditions of room temperature, a load of 3 kg during the test, and a holding time of 15 seconds. Here, 143 GPa was used as an elastic modulus of the thermoelectric conversion material. (See Japanese Journal of Applied Physics 54, 07JC03 (2015) M. Ishikawa et al.)

[Table 4]

| | Magnesium silicide | Boride | | Fracture toughness Kc (Pa·m$^{1/2}$) |
|---|---|---|---|---|
| | | Kind | Amount (mass%) | |
| Present Example 31 | Sb doped (0.2 atom%) | TiB$_2$ | 3.0 | 1.28 |
| Present Example 32 | Sb doped (0.2 atom%) | TiB$_2$ | 10.0 | 1.71 |
| Comparative Example 31 | Sb doped (0.2 atom%) | - | - | 0.98 |
| Young's modulus: 143 GPa is used for calculation | | | | |

In Present Examples 31 and 32 in which the boride was added, the fracture toughness Kc was higher than that of Comparative Example 31 in which the boride was not added. It was confirmed that the fracture strength was improved by adding the boride. It was also confirmed that the fracture toughness Kc increased as the amount of the boride added increased.

(Test 5)

In this test 5, the thermoelectric property of the thermoelectric conversion material in which Al was added to magnesium silicide (Mg$_2$Si) was evaluated.

In the same manufacturing method as in Test 1, an aluminum powder was added to the sintering raw material powder to obtain a thermoelectric conversion material having the compositions shown in Present Examples 41 to 45 in Table 5. As a raw material, an aluminum powder having a purity of 99.99 mass% (particle size 45 μm: manufactured by Kojundo Chemical Laboratory Co., Ltd.) was used.

The specific resistance value R, the Seebeck coefficient S, and the power factor PF of the thermoelectric conversion material obtained as described above at various temperatures were evaluated by the same method as in Test 1. Table 5 shows evaluation results.

[Table 5]

| | Magnesium silicide | Boride | | Al | Thermoelectric property evaluation | | | | | | |
| --- | --- | --- | --- | --- | --- | --- | --- | --- | --- | --- | --- |
| | | Kind | Amount (mass%) | Amount (mass%) | Evaluation item | 100°C | 200°C | 300°C | 400°C | 500°C | 550°C |
| Present Example 41 | Sb doped (0.2 atom%) | TiB$_2$ | 1.0 | 0.3 | Specific resistance | 1.94 | 1.92 | 2.21 | 2.66 | 3.24 | 3.55 |
| | | | | | Seebeck coefficient | -1.96 | -2.20 | -2.50 | -2.64 | -2.91 | -2.87 |
| | | | | | PF | 1.97 | 2.51 | 2.82 | 2.63 | 2.62 | 2.33 |
| Present Example 42 | Sb doped (0.2 atom%) | TiB$_2$ | 3.0 | 0.1 | Specific resistance | 1.92 | 1.91 | 2.15 | 2.68 | 3.16 | 3.35 |
| | | | | | Seebeck coefficient | -2.03 | -2.27 | -2.47 | -2.64 | -2.76 | -2.78 |
| | | | | | PF | 2.15 | 2.69 | 2.84 | 2.61 | 2.41 | 2.31 |
| Present Example 43 | Sb doped (0.2 atom%) | TiB$_2$ | 3.0 | 0.3 | Specific resistance | 1.89 | 1.80 | 2.14 | 2.60 | 3.20 | 3.24 |
| | | | | | Seebeck coefficient | -2.07 | -2.23 | -2.46 | -2.64 | -2.75 | -2.77 |
| | | | | | PF | 2.27 | 2.75 | 2.83 | 2.68 | 2.36 | 2.37 |
| Present Example 44 | Sb doped (0.2 atom%) | TiB$_2$ | 3.0 | 1.0 | Specific resistance | 1.86 | 1.77 | 2.09 | 2.58 | 3.14 | 3.21 |
| | | | | | Seebeck coefficient | -2.00 | -2.21 | -2.43 | -2.59 | -2.71 | -2.75 |
| | | | | | PF | 2.15 | 2.75 | 2.83 | 2.60 | 2.34 | 2.36 |
| Present Example 45 | Sb doped (0.2 atom%) | TiB$_2$ | 10.0 | 0.3 | Specific resistance | 1.69 | 1.64 | 1.96 | 2.39 | 3.00 | 3.17 |
| | | | | | Seebeck coefficient | -1.96 | -2.10 | -2.37 | -2.56 | -2.69 | -2.71 |
| | | | | | PF | 2.29 | 2.69 | 2.87 | 2.73 | 2.41 | 2.33 |

Specific resistance ($10^{-5} \cdot \Omega \cdot m$)
Seebeck coefficient ($10^{-4}$ V/K)
PF ($10^{-3}$ W/m·K$^2$)

EP 4 084 099 A1

In Present Examples 41 to 45 in which Al is added together with the boride, it is confirmed that the power factor PF is high at various temperatures and the thermoelectric property (power generation performance) are excellent.

(Test 6)

In this test 6, the oxidation resistance of the thermoelectric conversion material in which Al was added to magnesium silicide ($Mg_2Si$) was evaluated.

The thermoelectric conversion materials having the compositions shown in Table 6 were obtained by the same manufacturing method as in the test 5.

The thermoelectric conversion material obtained as described above was heattreated in a steam atmosphere in the same manner as in Test 2, and samples taken from the thermoelectric conversion material before and after the heat treatment were analyzed by an energy dispersive X-ray analysis (EDX) and the composition on the surface was confirmed. Table 6 shows measurement results.

[Table 6]

| | Magnesium silicide | Boride | | A1 | EDX analysis result of surface (atom%) | | | | | |
| | | Kind | Amount (mass%) | Amount (mass%) | Before heat treatment | | | After heat treatment | | |
| | | | | | O | Mg | Si | O | Mg | Si |
| Present Example 51 | Sb doped (0.2 atom%) | TiB$_2$ | 3.0 | 0.05 | 0.12 | 66.80 | 32.57 | 6.07 | 63.71 | 30.05 |
| Present Example 52 | Sb doped (0.2 atom%) | TiB$_2$ | 3.0 | 0.3 | 0.09 | 66.88 | 32.70 | 5.71 | 63.53 | 30.46 |
| Present Example 53 | Sb doped (0.2 atom%) | TiB$_2$ | 3.0 | 1.0 | 0.16 | 66.51 | 32.49 | 4.25 | 63.93 | 31.40 |
| Present Example 54 | Sb doped (0.2 atom%) | TiB$_2$ | 10.0 | 0.3 | 0.11 | 66.73 | 32.62 | 3.68 | 64.26 | 31.87 |

In Present Examples 51 to 54 in which the boride and Al were added, the amount of oxygen (O) was slightly higher after the heat treatment, but there was no significant change in the amount of magnesium (Mg) and silicon (Si). That is, it was confirmed that the formation of the magnesium oxide could be suppressed also in Present Examples 51 to 54.

(Test 7)

In this test 7, the thermoelectric property of the thermoelectric conversion material containing $Mg_2Si_XSn_{1-X}$ (where $0.3 \leq X \leq 1$) as a main component was evaluated.

The thermoelectric conversion materials having the compositions shown in Tables 7 to 9 were obtained by the same manufacturing method as in the test 1.

Specifically, according to the method for manufacturing a magnesium silicide powder in Test 1, a magnesium powder, a silicon powder, and a tin powder were weighed respectively and mixed, and an ingot of $Mg_2Si_XSn_{1-X}$ (were $0.3 \leq X \leq 1$) was produced, and the ingot was pulverized to produce $Mg_2Si_XSn_{1-X}$ (where $0.3 \leq X \leq 1$) powder. Next, a boride powder which was the same as in Test 1 was prepared, weighed so as to have the amount shown in Table 7, and the $Mg_2Si_XSn_{1-X}$ (where $0.3 \leq X \leq 1$) powder and the boride powder were mixed to obtain a sintering raw material powder. An aluminum powder was added to the sintering raw material powder as needed. Moreover, using the obtained sintering raw material powder, the thermoelectric conversion materials shown in Present Examples 61, 62, 71 to 74, and 81 to 84 and Comparative Examples 61, 71, 72, and 81 in Tables 7 to 9 were obtained in the same method as in Test 1.

As raw materials, a tin powder having a purity of 99.99 mass% (particle size 150 $\mu$m: manufactured by Kojundo Chemical Laboratory Co., Ltd.) and an aluminum powder having a purity of 99.99 mass% (particle size 45 $\mu$m: manufactured by Kojundo Chemical Laboratory Co., Ltd.) were used.

The specific resistance value R, the Seebeck coefficient S, and the power factor PF of the thermoelectric conversion material obtained as described above at various temperatures were evaluated by the same method as in Test 1. Tables 7 to 9 show evaluation results.

[Table 7]

| | $Mg_2Si_xSn_{1-x}$ | | Boride | | Al | Thermoelectric property evaluation | | | | | | | |
|---|---|---|---|---|---|---|---|---|---|---|---|---|---|
| | X | Sb (atom%) | Kind | Amount (mass%) | Amount (mass%) | Evaluation item | 20°C | 50°C | 100°C | 200°C | 300°C | 400°C | 450°C |
| Present Example 61 | 0.4 | 0.5 | $TiB_2$ | 3.0 | - | Specific resistance | 4.17 | 4.15 | 4.30 | 4.69 | 4.91 | 4.46 | 4.15 |
| | | | | | | Seebeck coefficient | -2.72 | -2.69 | -2.87 | -3.08 | -3.11 | -2.80 | -2.55 |
| | | | | | | PF | 1.78 | 1.74 | 1.91 | 2.03 | 1.97 | 1.75 | 1.56 |
| Present Example 62 | 0.4 | 0.5 | $TiB_2$ | 7.0 | - | Specific resistance | 4.10 | 4.05 | 4.18 | 4.52 | 4.57 | 4.00 | 3.69 |
| | | | | | | Seebeck coefficient | -2.67 | -2.67 | -2.83 | -3.03 | -3.01 | -2.66 | -2.40 |
| | | | | | | PF | 1.74 | 1.77 | 1.91 | 2.03 | 1.99 | 1.77 | 1.57 |
| Comparative Example 61 | 0.4 | 0.5 | $TiB_2$ | - | - | Specific resistance | 4.26 | 4.36 | 4.53 | 5.09 | 5.47 | 5.18 | 4.82 |
| | | | | | | Seebeck coefficient | -2.68 | -2.70 | -2.85 | -3.10 | -3.18 | -2.93 | -2.68 |
| | | | | | | PF | 1.69 | 1.68 | 1.80 | 1.89 | 1.85 | 1.66 | 1.49 |

Specific resistance ($10^{-5} \cdot \Omega \cdot m$)
Seebeck coefficient ($10^{-4}$ V/K)
PF ($10^{-3}$ W/m·K$^2$)

EP 4 084 099 A1

[Table 8]

| | Mg$_2$Si$_x$Sn$_{1-x}$ | | Boride | | Al | Thermoelectric property evaluation | | | | | | | |
|---|---|---|---|---|---|---|---|---|---|---|---|---|---|
| | X | Sb (atom%) | Kind | Amount (mass%) | Amount (mass%) | Evaluation item | 20°C | 50°C | 100°C | 200°C | 300°C | 400°C | 450°C |
| Present Example 71 | 0.5 | 0.5 | TiB$_2$ | 3.0 | 0.3 | Specific resistance | 3.25 | 3.19 | 3.32 | 3.67 | 4.00 | 3.94 | 3.79 |
| | | | | | | Seebeck coefficient | -2.03 | -2.01 | -2.21 | -2.56 | -2.81 | -2.80 | -2.71 |
| | | | | | | PF | 1.27 | 1.26 | 1.46 | 1.78 | 1.98 | 1.99 | 1.94 |
| Present Example 72 | 0.5 | 0.5 | TiB$_2$ | 7.0 | 0.3 | Specific resistance | 2.85 | 2.89 | 2.95 | 3.31 | 3.65 | 3.63 | 3.46 |
| | | | | | | Seebeck coefficient | -1.85 | -1.89 | -2.10 | -2.45 | -2.70 | -2.72 | -2.66 |
| | | | | | | PF | 1.20 | 1.24 | 1.49 | 1.82 | 1.99 | 2.04 | 2.05 |
| Present Example 73 | 0.5 | 0.5 | TiB$_2$ | 3.0 | 0.06 | Specific resistance | 3.15 | 3.12 | 3.25 | 3.55 | 3.80 | 3.76 | 3.66 |
| | | | | | | Seebeck coefficient | -1.95 | -1.96 | -2.16 | -2.51 | -2.69 | -2.68 | -2.63 |
| | | | | | | PF | 1.21 | 1.23 | 1.44 | 1.77 | 1.90 | 1.91 | 1.90 |
| Present Example 74 | 0.5 | 0.5 | TiB$_2$ | 3.0 | 1.0 | Specific resistance | 3.10 | 3.07 | 3.16 | 3.43 | 3.70 | 3.66 | 3.59 |
| | | | | | | Seebeck coefficient | -1.93 | -1.95 | -2.12 | -2.43 | -2.63 | -2.64 | -2.58 |
| | | | | | | PF | 1.21 | 1.24 | 1.43 | 1.73 | 1.86 | 1.90 | 1.86 |
| Comparative Example 71 | 0.5 | 0.5 | TiB$_2$ | - | - | Specific resistance | 3.44 | 3.45 | 3.57 | 3.95 | 4.40 | 4.59 | 4.43 |
| | | | | | | Seebeck coefficient | -1.99 | -2.08 | -2.24 | -2.60 | -2.83 | -2.89 | -2.80 |
| | | | | | | PF | 1.16 | 1.25 | 1.40 | 1.71 | 1.82 | 1.82 | 1.74 |

EP 4 084 099 A1

(continued)

| | Mg$_2$Si$_x$Sn$_{1-x}$ | | Boride | | Al | Evaluation item | Thermoelectric property evaluation | | | | | | |
|---|---|---|---|---|---|---|---|---|---|---|---|---|---|
| | X | Sb (atom%) | Kind | Amount (mass%) | Amount (mass%) | | 20°C | 50°C | 100°C | 200°C | 300°C | 400°C | 450°C |
| Comparative Example 72 | 0.5 | 0.5 | TiB$_2$ | - | 0.32 | Specific resistance | 3.34 | 3.35 | 3.46 | 3.90 | 4.37 | 4.33 | 4.13 |
| | | | | | | Seebeck coefficient | -1.93 | -2.02 | -2.20 | -2.56 | -2.82 | -2.85 | -2.79 |
| | | | | | | PF | 1.12 | 1.21 | 1.40 | 1.69 | 1.82 | 1.88 | 1.88 |

Specific resistance (10$^{-5}$ Ω·m)
Seebeck coefficient (10$^{-4}$ V/K)
PF (10$^{-3}$ W/m·K$^2$)

[Table 9]

| | Mg₂SiₓSn₁₋ₓ | | Boride | | Al | Thermoelectric property evaluation | | | | | | | |
|---|---|---|---|---|---|---|---|---|---|---|---|---|---|
| | X | Sb (atom%) | Kind | Amount (mass%) | Amount (mass%) | Evaluation item | 20°C | 50°C | 100°C | 200°C | 300°C | 400°C | 450°C |
| Present Example 81 | 0.35 | 0.5 | TiB₂ | 3.0 | - | Specific resistance | 4.04 | 4.16 | 4.35 | 4.81 | 4.94 | 4.39 | 4.02 |
| | | | | | | Seebeck coefficient | -2.86 | -2.89 | -3.02 | -3.20 | -3.12 | -2.68 | -2.39 |
| | | | | | | PF | 2.03 | 2.00 | 2.10 | 2.14 | 1.97 | 1.63 | 1.42 |
| Present Example 82 | 0.35 | 0.5 | TiB₂ | 3.0 | 0.05 | Specific resistance | 4.00 | 4.10 | 4.29 | 4.77 | 4.89 | 4.30 | 3.98 |
| | | | | | | Seebeck coefficient | -2.87 | -2.90 | -3.01 | -3.22 | -3.13 | -2.74 | -2.47 |
| | | | | | | PF | 2.06 | 2.05 | 2.11 | 2.17 | 2.01 | 1.74 | 1.53 |
| Present Example 83 | 0.35 | 0.5 | TiB₂ | 3.0 | 0.3 | Specific resistance | 3.88 | 4.00 | 4.16 | 4.72 | 4.87 | 4.20 | 3.92 |
| | | | | | | Seebeck coefficient | -2.86 | -2.89 | -2.99 | -3.21 | -3.18 | -2.75 | -2.49 |
| | | | | | | PF | 2.10 | 2.09 | 2.15 | 2.18 | 2.08 | 1.80 | 1.59 |
| Present Example 84 | 0.35 | 0.5 | TiB₂ | 3.0 | 1.0 | Specific resistance | 3.87 | 3.99 | 4.11 | 4.66 | 4.80 | 4.11 | 3.87 |
| | | | | | | Seebeck coefficient | -2.84 | -2.87 | -2.96 | -3.18 | -3.11 | -2.69 | -2.43 |
| | | | | | | PF | 2.08 | 2.07 | 2.13 | 2.17 | 2.01 | 1.77 | 1.53 |

(continued)

| | Mg₂SiₓSn₁₋ₓ | | Boride | | Al | Thermoelectric property evaluation | | | | | | | |
|---|---|---|---|---|---|---|---|---|---|---|---|---|---|
| | X | Sb (atom%) | Kind | Amount (mass%) | Amount (mass%) | Evaluation item | 20°C | 50°C | 100°C | 200°C | 300°C | 400°C | 450°C |
| Comparative Example 81 | 0.35 | 0.5 | TiB₂ | - | - | Specific resistance | 4.21 | 4.28 | 4.50 | 5.05 | 5.30 | 4.78 | 4.35 |
| | | | | | | Seebeck coefficient | -2.85 | -2.83 | -2.99 | -3.20 | -3.18 | -2.79 | -2.53 |
| | | | | | | PF | 1.93 | 1.87 | 1.99 | 2.02 | 1.91 | 1.63 | 1.47 |

Specific resistance ($10^{-5} \cdot \Omega \cdot m$)
Seebeck coefficient ($10^{-4}$ V/K)
PF ($10^{-3}$ W/m·K²)

In the thermoelectric conversion material containing $Mg_2Si_XSn_{1-X}$ (X = 0.4) as a main component, in Present Examples 61 and 62 in which the boride was added, it was confirmed that the power factor PF was high at various temperatures and the thermoelectric property (power generation performance) was excellent, comparing to Comparative Example 61 in which the boride was not added.

In the thermoelectric conversion material containing $Mg_2Si_XSn_{1-X}$ (X = 0.5) as a main component, in Present Examples 71 to 74 in which the boride was added, it was confirmed that the power factor PF was high at various temperatures and the thermoelectric property (power generation performance) was excellent, comparing to Comparative Examples 71 and 72 in which the boride was not added.

In the thermoelectric conversion material containing $Mg_2Si_XSn_{1-X}$ (X = 0.35) as a main component, in Present Examples 81 to 84 in which the boride was added, it was confirmed that the power factor PF was high at various temperatures and the thermoelectric property (power generation performance) was excellent, comparing to Comparative Example 81 in which the boride was not added.

(Test 8)

In this test 8, the hardness, the toughness, and the strength of the thermoelectric conversion material containing $Mg_2Si_XSn_{1-X}$ (where $0.3 \leq X \leq 1$) as a main component was evaluated. The thermoelectric conversion materials having the compositions shown in Present Examples 91 and 92 and Comparative Examples 91 to 95 in Table 10 were obtained by the same manufacturing method as in the test 7. As raw materials, a tin powder having a purity of 99.99 mass% (particle size 150 $\mu$m: manufactured by Kojundo Chemical Laboratory Co., Ltd.) and an aluminum powder having a purity of 99.99 mass% (particle size 45 $\mu$m: manufactured by Kojundo Chemical Laboratory Co., Ltd.) were used.

The Vickers hardness, the length of cracks formed at an end of the indentation during the Vickers hardness test, and the bending strength during three-point bending of the thermoelectric conversion material obtained as described above were evaluated by the same method as in Tests 3 and 4. Table 10 shows evaluation results.

[Table 10]

| | $Mg_2Si_XSn_{1-x}$ | | Boride | | Al | Vickers hardness (HV) | Crack length ($\mu$m) | Bending strength (MPa) |
|---|---|---|---|---|---|---|---|---|
| | X | Sb (atom%) | Kind | Amount (mass%) | Amount (mass%) | | | |
| Present Example 91 | 0.4 | 0.5 | TiB$_2$ | 3.0 | - | 376 | 439 | 61 |
| Present Example 92 | 0.4 | 0.5 | TiB$_2$ | 7.0 | - | 383 | 424 | 64 |
| Comparative Example 91 | 0.4 | 0.5 | - | - | - | 346 | 471 | 52 |
| Present Example 93 | 0.5 | 0.5 | TiB$_2$ | 3.0 | 0.3 | 389 | 422 | 64 |
| Present Example 94 | 0.5 | 0.5 | TiB$_2$ | 7.0 | 0.3 | 393 | 410 | 69 |
| Comparative Example 93 | 0.5 | 0.5 | - | - | - | 358 | 453 | 55 |
| Present Example 95 | 0.35 | 0.5 | TiB$_2$ | 3.0 | - | 368 | 450 | 57 |
| Comparative Example 95 | 0.35 | 0.5 | - | - | - | 340 | 481 | 50 |

In the thermoelectric conversion material containing $Mg_2Si_XSn_{1-X}$ (X = 0.4) as a main component, in Present Examples 91 and 92 in which the boride was added, it is confirmed that the Vickers hardness and the bending strength were high, comparing to Comparative Example 91 in which the boride was not added. In addition, it is also confirmed that the crack length is short and the fracture toughness is also excellent.

In the thermoelectric conversion material containing $Mg_2Si_XSn_{1-X}$ (X = 0.5) as a main component, in Present Examples 93 and 94 in which the boride was added, it was confirmed that the Vickers hardness and the bending strength were high, comparing to Comparative Example 93 in which the boride was not added. In addition, it is also confirmed that the crack length is short and the fracture toughness is also excellent.

In the thermoelectric conversion material containing $Mg_2Si_XSn_{1-X}$ (X = 0.35) as a main component, in Present Example 95 of the present invention to which boride was added, it is confirmed that the Vickers hardness and the bending strength were high comparing to Comparative Example 95 in which boride was not added. In addition, it is also confirmed that the crack length is short and the fracture toughness is also excellent.

From the above, it was confirmed that according to the present examples, it is possible to provide a thermoelectric conversion material excellent in the thermoelectric property, the oxidation resistance, and the strength.

[Reference Signs List]

1: Thermoelectric conversion module
10: Thermoelectric conversion element
11: Thermoelectric conversion material
18a, 18b: Electrode
19a, 19b: Terminal

**Claims**

1. A thermoelectric conversion material comprising:

   $Mg_2Si_XSn_{1-X}$ (where $0.3 \leq X \leq 1$); and
   a boride containing one or two or more metals selected from titanium, zirconium, and hafnium.

2. The thermoelectric conversion material according to Claim 1,
   wherein the $Mg_2Si_XSn_{1-X}$ is a magnesium silicide with X = 1.

3. The thermoelectric conversion material according to Claim 1 or 2,
   wherein the boride is one or two or more selected from $TiB_2$, $ZrB_2$, and $HfB_2$.

4. The thermoelectric conversion material according to any one of Claims 1 to 3,
   wherein a mass ratio of the $Mg_2Si_XSn_{1-X}$ to the thermoelectric conversion material is within a range of 84 mass% or more and 99.5 mass% or less.

5. The thermoelectric conversion material according to any one of Claims 1 to 4,
   wherein a total amount of the boride to the thermoelectric conversion material is within a range of 0.5 mass% or more and 15 mass% or less.

6. The thermoelectric conversion material according to any one of Claims 1 to 5, further comprising:
   aluminum.

7. The thermoelectric conversion material according to Claim 6,
   wherein an amount of the aluminum to the thermoelectric conversion material is within a range of 0.01 mass% or more and 1 mass% or less.

8. A thermoelectric conversion element comprising:

   the thermoelectric conversion material according to any one of Claims 1 to 7; and
   electrodes which are respectively joined to one surface of the thermoelectric conversion material and the other surface opposite the one surface.

9. A thermoelectric conversion module comprising:

   the thermoelectric conversion element according to Claim 8; and
   terminals which are respectively joined to the electrodes of the thermoelectric conversion element.

# FIG. 1

# FIG. 2

# FIG. 3

FIG. 4

# FIG. 5

(a) PRESENT EXAMPLE 11

(b) PRESENT EXAMPLE 12

(c) COMPARATIVE EXAMPLE 11

(d) COMPARATIVE EXAMPLE 12

**INTERNATIONAL SEARCH REPORT**

| International application No. |
|---|
| PCT/JP2020/047992 |

A.    CLASSIFICATION OF SUBJECT MATTER
H01L  35/14(2006.01)i;  B22F  3/14(2006.01)i;  B22F  9/04(2006.01)i;  C01B 33/06(2006.01)i;  C22C  1/05(2006.01)i;  C22C  23/00(2006.01)i;  H01L 35/22(2006.01)i; H01L 35/26(2006.01)i
FI:  H01L35/14;  B22F3/14  101B;  B22F9/04  C;  C01B33/06;  C22C1/05  E; C22C23/00; H01L35/22; H01L35/26

According to International Patent Classification (IPC) or to both national classification and IPC

B.    FIELDS SEARCHED

Minimum documentation searched (classification system followed by classification symbols)
H01L35/14; B22F3/14; B22F9/04; C01B33/06; C22C1/05; C22C23/00; H01L35/22; H01L35/26

Documentation searched other than minimum documentation to the extent that such documents are included in the fields searched
Published examined utility model applications of Japan    1922–1996
Published unexamined utility model applications of Japan   1971–2021
Registered utility model specifications of Japan       1996–2021
Published registered utility model applications of Japan   1994–2021

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
|---|---|---|
| X Y | JP 2016-164960 A (MITSUBISHI CHEMICAL CORP.) 08 September 2016 (2016-09-08) paragraphs [0014], [0020]-[0025], [0035]-[0036], [0042] | 1-3, 6 1-9 |
| Y | JP 2013-008747 A (IBARAKI UNIVERSITY) 10 January 2013 (2013-01-10) paragraphs [0037]-[0038] | 1-9 |
| Y | JP 2019-145661 A (MITSUBISHI MATERIALS CORP.) 29 August 2019 (2019-08-29) paragraphs [0019]-[0020], fig. 1 | 8-9 |

☐   Further documents are listed in the continuation of Box C.    ☒   See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 March 2021 (09.03.2021) | 16 March 2021 (16.03.2021) |

| Name and mailing address of the ISA/ Japan Patent Office 3-4-3, Kasumigaseki, Chiyoda-ku, Tokyo 100-8915, Japan | Authorized officer Telephone No. |
|---|---|

Form PCT/ISA/210 (second sheet) (January 2015)

INTERNATIONAL SEARCH REPORT

Information on patent family members

International application No.

PCT/JP2020/047992

| Patent Documents referred in the Report | Publication Date | Patent Family | Publication Date |
|---|---|---|---|
| JP 2016-164960 A | 08 Sep. 2016 | (Family: none) | |
| JP 2013-008747 A | 10 Jan. 2013 | (Family: none) | |
| JP 2019-145661 A | 29 Aug. 2019 | WO 2019/163807 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019233147 A
- JP 2020134901 A
- JP 2013179322 A
- JP 2017050325 A

**Non-patent literature cited in the description**

- **M. ISHIKAWA.** *Japanese Journal of Applied Physics,* 2015, vol. 54, 07JC03